# EUROPÄISCHE PATENTANMELDUNG

(11) **EP 3 664 105 A1**
(43) Veröffentlichungstag der Anmeldung: **10.06.2020**
(21) Anmeldenummer: 20150446.1
(22) Anmeldetag: 05.12.2012
(51) Int. Cl.: H01C 1/084, G01R 1/20

(54) **STROMMESSWIDERSTAND**

(30) Priorität: 05.12.2011 DE 102011120276; 21.12.2011 DE 102011121902
(62) Teilanmeldung aus: 12008143.5
(71) Anmelder: Isabellenhütte Heusler GmbH & Co. KG, 35683 Dillenburg (DE)
(72) Erfinder: Hetzler, Ullrich, 35688 Dillenburg-Oberscheld (DE)
(74) Vertreter: v. Bezold & Partner Patentanwälte - PartG mbB

(57) **Zusammenfassung**

Die Erfindung betrifft einen Leistungswiderstand (1), insbesondere einen Strommesswiderstand zur Messung eines elektrischen Stroms, mit zwei Anschlussteilen (2, 3) aus einem Leitermaterial zum Einleiten bzw. Abführen eines elektrischen Stroms und einem niederohmigen Widerstandselement (4), wobei der elektrische Strom eine elektrische Verlustwärme in dem Widerstandselement (4) erzeugt. Die Erfindung sieht eine Wärmesenke (12, 13) vor, die thermisch und physisch mit dem Widerstandselement (4) verbunden ist und die in dem Widerstandselement (4) entstehende elektrische Verlustwärme mindestens teilweise aufnimmt und abführt.

## Beschreibung

Die Erfindung betrifft einen Widerstand, insbesondere einen Strommesswiderstand zur Messung eines elektrischen Stroms.

Aus EP 605 800 A1 ist ein derartiger Strommesswiderstand bekannt, der aus zwei plattenförmigen Anschlussteilen aus Kupfer und einem zwischen die beiden Anschlussteile eingesetzten niederohmigen Widerstandselement aus Manganin® besteht. Hierbei wird der zu messende elektrische Strom über die Anschlussteile in den Strommesswiderstand eingeleitet bzw. von dem Strommesswiderstand abgeführt, so dass der zu messende elektrische Strom durch das niederohmige Widerstandselement fließt und dabei einen Spannungsabfall über dem Widerstandselement erzeugt, der entsprechend dem Ohmschen Gesetz proportional zu dem zu messenden elektrischen Strom ist. Bei einer Strommessung gemäß der bekannten Vierleitertechnik wird der zu messende elektrische Strom also über zwei Leiter in dem Strommesswiderstand eingeleitet bzw. daraus abgeführt, während über zwei weitere Leiter die Spannung gemessen wird, die über dem Widerstandselement abfällt.

Problematisch an derartigen Strommesswiderständen ist die hohe Verlustwärme, die im Kurzschlussfall in dem Widerstandselement erzeugt wird und zu einer entsprechenden Erwärmung des Widerstandselements führt.

Der Erfindung liegt deshalb die Aufgabe zugrunde, einen entsprechend verbesserten Widerstand zu schaffen.

Diese Aufgabe wird durch einen erfindungsgemäßen Widerstand gemäß dem Hauptanspruch gelöst.

Der erfindungsgemäße Widerstand weist in Übereinstimmung mit dem eingangs beschriebenen herkömmlichen Strommesswiderstand zwei Anschlussteile aus einem elektrisch leitfähigen Leitermaterial auf, um den elektrischen Strom in den Widerstand einzuleiten bzw. aus dem Widerstand abzuführen. Bei dem Leitermaterial der beiden Anschlussteile handelt es sich vorzugsweise um Kupfer oder eine Kupferlegierung, da deren spezifischer elektrischer Widerstand äußerst gering ist. Die Erfindung ist jedoch hinsichtlich des Leitermaterials der Anschlussteile nicht auf Kupfer oder Kupferlegierungen beschränkt, sondern grundsätzlich auch mit anderen Leitermaterialien realisierbar, die einen hinreichend geringen spezifischen elektrischen Widerstand aufweisen. Vorzugsweise ist der spezifische elektrische Widerstand des Leitermaterials kleiner als 10⁻⁵ Ω·m, 10⁻⁶ Ω·m oder sogar kleiner als 10⁻⁷ Ω·m. Insbesondere ist auch eine Ausführung der Anschlussteile in der Form denkbar, dass Cu-Plättchen oder Plättchen eines anderen leitfähigen Materials flächig auf das entsprechend verlängerte Widerstandmaterial aufgelötet oder geschweißt sind.

Darüber hinaus weist der erfindungsgemäße Widerstand in Übereinstimmung mit dem eingangs beschriebenen herkömmlichen Strommesswiderstand ein Widerstandselement auf, das im Stromflusspfad zwischen den beiden Anschlussteilen angeordnet ist, so dass der elektrische Strom durch das Widerstandselement fließt und dabei eine elektrische Verlustwärme in dem Widerstandselement erzeugt. Das Widerstandselement besteht hierbei aus einem Widerstandsmaterial, dessen spezifischer elektrischer Widerstand größer ist als der spezifische elektrische Widerstand des Leitermaterials der beiden Anschlussteile. Beispielsweise kann es sich bei dem Widerstandsmaterial des Widerstandselements um eine Nickellegierung handeln, wie beispielsweise Nickel-Chrom oder Kupfer-Nickel.

Vorzugsweise wird im Rahmen der Erfindung ein Widerstandsmaterial verwendet, das gegenüber dem Leitermaterial (z.B. Kupfer) nur eine geringe Thermospannung aufweist. Dies ist vorteilhaft, da die Strommessung dann kaum durch Thermospannungen verfälscht wird. Vorzugsweise zeigt das Widerstandsmaterial deshalb in der Thermoelektrischen Spannungsreihe gegenüber Kupfer eine Thermospannung von weniger als 1 mV/100K, 0,5 mV/100K oder sogar weniger als 0,2 mV/100K.

Hierbei ist zu erwähnen, dass das Widerstandsmaterial vorzugsweise niederohmig ist und einen spezifischen elektrischen Widerstand aufweist, der vorzugsweise kleiner ist als 10⁻⁴ Ω·m, 10⁻⁵ Ω·m oder sogar kleiner als 10⁻⁶ Q.m.

Für eine möglichst temperaturkonstante Messung ist es weiterhin vorteilhaft, wenn das Widerstandsmaterial einen spezifischen elektrischen Widerstand mit einem möglichst kleinen linearen Temperaturkoeffizienten aufweist. Bei dem erfindungsgemäßen Widerstand ist der Temperaturkoeffizient des Widerstandsmaterials deshalb vorzugsweise kleiner als 5·10⁻⁴ K⁻¹, 2·10⁻⁴ K⁻¹, 10⁻⁴ K⁻¹ oder sogar kleiner als 5·10⁻⁵ K⁻¹.

Es wurde bereits vorstehend erwähnt, dass der durch den Widerstand fließende elektrische Strom in dem Widerstandselement eine elektrische Verlustwärme erzeugt, die zu einer entsprechenden Erwärmung des Widerstandselements führt, was insbesondere im Kurzschlussfall relevant ist. Zur zwischenzeitlichen Speicherung und Abführung dieser elektrischen Verlustwärme weist der erfindungsgemäße Widerstand deshalb zusätzlich eine Wärmesenke auf, die thermisch und physisch mit dem Widerstandselement verbunden ist und die in dem Widerstandselement entstehende elektrische Verlustwärme mindestens teilweise aufnimmt und abführt.

Zum einen erfüllt die Wärmesenke also die technische Funktion eines Wärmepuffers, der die im Kurzschlussfall auftretende elektrische Verlustwärme kurzzeitig zwischenspeichert, bevor die Verlustwärme dann endgültig nach außen abgeführt wird. Zur Erfüllung dieser technischen Funktion weist die Wärmesenke vorzugsweise eine große Wärmekapazität auf, damit die Wärmesenke im Kurzschlussfall möglichst viel Wärme speichern kann. Die Wärmesenke besteht deshalb vorzugsweise aus einem metallischen Wärmesenkenmaterial mit hoher Wärmekapazität. Die Wärmekapazität der Wärmesenke lässt sich jedoch nicht nur durch eine geeignete Materialauswahl steigern, sondern auch durch die Verwendung einer möglichst großen und schweren Wärmesenke. Bei dem erfindungsgemäßen Widerstand weist die Wärmesenke deshalb vorzugsweise ein wesentlich größeres Bauvolumen und/oder eine wesentlich größere Masse auf als das Widerstandselement selbst. Wichtig ist hierbei, dass die Wärmesenke eine größere Wärmekapazität aufweist als das Widerstandselement, wobei die Wärmekapazität der Wärmesenke vorzugsweise um einen Faktor von mindestens 10, 20 oder sogar 30 größer ist als die Wärmekapazität des Widerstandselements.

Zum anderen soll die Wärmesenke aber auch die technische Funktion der Wärmeabführung erfüllen, d.h. die Wärmesenke soll die elektrische Verlustwärme nicht nur kurzzeitig zwischenspeichern, sondern auch nach außen abführen. Zur Erfüllung dieser technischen Funktion ist eine möglichst gute Wärmeleitfähigkeit des Wärmesenkenmaterials und eine gute Ableitung der Wärme an die Umgebung n von Bedeutung. Das Wärmesenkenmaterial weist deshalb vorzugsweise eine spezifische Wärmeleitfähigkeit von mehr als 100 W/m·K, 150 W/m·K oder sogar mehr als 200 W/m·K auf. Zusätzlich ist eine gute Ableitung der Wärme an die Umgebung von Bedeutung, z.B. über die massiven Cu-Anschlusskontakte der Stromzuführung oder die Oberflächen.

Die vorstehend genannten technischen Funktionen (Wärmespeicherung und Wärmeabführung) werden vorteilhaft von einer Wärmesenke realisiert, die aus Aluminium oder aus einer Aluminiumlegierung besteht.

In einem bevorzugten Ausführungsbeispiel der Erfindung ist die Wärmesenke mehrteilig und besteht aus einem Oberteil und einem Unterteil, wobei das Oberteil das Widerstandselement an dessen Oberseite thermisch und physisch kontaktiert, während das Unterteil der Wärmesenke das Widerstandselement an dessen Unterseite thermisch und physisch kontaktiert. Vorzugsweise wird das Widerstandselement hierbei oben und unten auf seiner gesamten Fläche von der Wärmesenke kontaktiert, um einen möglichst guten Wärmeübergang von dem Widerstandselement auf die Wärmesenke zu erreichen.

Es wurde bereits vorstehend erwähnt, dass die Wärmesenke vorzugsweise aus einem Wärmesenkenmaterial mit einer guten thermischen Leitfähigkeit besteht. Eine gute thermische Leitfähigkeit korrespondiert jedoch in der Regel auch mit einer guten elektrischen Leitfähigkeit, die bei einem Berührungskontakt zwischen der Wärmesenke und dem Widerstand zu einem Kurzschluss führen könnte. In dem bevorzugten Ausführungsbeispiel der Erfindung ist die Wärmesenke deshalb von einer elektrisch isolierenden Oberflächenschicht umgeben, um einen derartigen Kurzschluss zu vermeiden. Bei einem Aluminium-Bauteil kann diese elektrisch isolierende Oberflächenschicht beispielsweise durch einen Eloxiervorgang erzeugt werden, was an sich aus dem Stand der Technik bekannt ist. In dem bevorzugten Ausführungsbeispiel besteht die Wärmesenke also aus einem elektrisch und thermisch leitfähigen Aluminium-Bauteil mit einer elektrisch isolierenden Oxidschicht an der Oberfläche.

Es wurde bereits vorstehend darauf hingewiesen, dass ein möglichst guter Wärmeübergang zwischen dem Widerstandselement und der Wärmesenke vorteilhaft ist, um die bei einem Kurzschluss auftretende Erwärmung des Widerstandselements möglichst gering zu halten. Zwischen der Wärmesenke und dem Widerstandselement ist deshalb vorzugsweise ein Wärmeleitmittel angeordnet, wie beispielsweise eine Wärmeleitpaste oder konkret eine Keramikpaste. Dieses Material ist als dünne Schicht aufgetragen, um kleinste Unebenheiten von Shunt und Kühlkörper auszugleichen und damit einen guten Wärmeübergang zwischen Shunt und Kühlkörpern zu garantieren.

In dem bevorzugten Ausführungsbeispiel der Erfindung weist der Strommesswiderstand zwei integrierte Spannungsabgriffe auf, um die über dem Widerstandselement abfallende elektrische Spannung zu messen. Die beiden Spannungsabgriffe sind deshalb jeweils an den beiden Anschlussteilen (am Übergang zwischen Widerstandsmaterial und den Cu-Anschlussteilen) angebracht und vorzugsweise elektrisch und physisch mit den beiden Anschlussteilen verbunden. Darüber hinaus weist der erfindungsgemäße Widerstand in dem bevorzugten Ausführungsbeispiel zwei integrierte Messleitungen auf, die an die beiden Spannungsabgriffe angeschlossen sind, wobei die beiden Messleitungen mit einem Teil ihrer Länge innerhalb des erfindungsgemäßen Widerstands verlaufen.

Vorzugsweise sind die beiden Messleitungen des erfindungsgemäßen Widerstands als Streifenleiter ausgebildet, d.h. die beiden Leitungen liegen in einer Flexleitung deckungsgleich in sehr geringem Abstand (z.B. 25pm) übereinander, was die Empfindlichkeit gegenüber Störeinstrahlung verringert und das Frequenzverhalten des Shunts erheblich verbessert.

Zur Führung der beiden Messleitungen kann das Widerstandselement auch eine Nut oder einen Schlitz aufweisen, so dass die Messleitungen zwischen dem Widerstandselement und der Wärmesenke verlaufen können, ohne den Wärmekontakt zwischen dem Widerstandselement und der Wärmesenke wesentlich zu beeinträchtigen.

Die Führung der beiden Messleitungen von den außen liegenden Anschlussteilen nach innen ist vorteilhaft, weil dadurch die Induktivität der Messschleife verringert und der Frequenzgang verbessert wird. Die beiden Messleitungen sind deshalb vorzugsweise zu einem gemeinsamen Anschlusspunkt in der Mitte zwischen den beiden Anschlussteilen geführt, von wo die beiden Messleitungen in einem gemeinsamen Kabelstrang nach außen geführt sind. Weiterhin ist zu erwähnen, dass die Anschlussteile eine Prägung aufweisen können zur Aufnahme der vorstehend erwähnten Spannungsabgriffe.

In dem bevorzugten Ausführungsbeispiel ist die Wärmesenke mit dem Widerstandselement und/oder mit den Anschlussteilen mechanisch fest verbunden, beispielsweise durch eine Schraubverbindung oder durch eine Nietverbindung.

Ferner ist zu erwähnen, dass das Widerstandselement vorzugsweise in der Mitte zwischen den beiden Anschlussteilen einen größeren Stromflussquerschnitt aufweist als außen an den Kontaktstellen zu den Anschlussteilen. Dies ist vorteilhaft, weil der größere Stromflussquerschnitt in der Mitte zwischen den beiden Anschlussteilen dort zu einem entsprechend kleineren Ohmschen Widerstand führt, so dass in der Mitte zwischen den beiden Anschlussteilen entsprechend weniger Verlustleistung erzeugt wird. Dies ist wiederum vorteilhaft, weil die Abführung der elektrischen Verlustleistung im Wesentlichen über die außen liegenden Anschlussteile erfolgt, so dass außen in der Nähe der Anschlussteile auch eine größere elektrische Verlustleistung erzeugt werden sollte.

Weiterhin ist zu erwähnen, dass das Widerstandselement in dem bevorzugten Ausführungsbeispiel der Erfindung wesentlich dünner ist als die Anschlussteile.

Bei dem bevorzugten Ausführungsbeispiel der Erfindung erstreckt sich die Wärmesenke nicht nur über den Bereich des Widerstandselements, sondern in seitlicher Richtung zumindest auch teilweise über eine der beiden Anschlussteile. Beispielsweise kann die Wärmesenke zur Verbesserung der Wärmeableitung zum Stromanschlusskontakt eine Zunge aufweisen, die seitlich in Deckung über einer entsprechenden Zunge eines der beiden Anschlussteile liegt, wobei eine Anschlussbohrung durch die beiden Zungen von Anschlussteil und Wärmesenke hindurchgehen kann.

Ferner ist noch zu erwähnen, dass die Anschlussteile und/oder das Widerstandselement vorzugsweise plattenförmig sind, wobei auch eine gebogene Plattenform in Frage kommt.

Andere vorteilhafte Weiterbildungen der Erfindung sind in den Unteransprüchen gekennzeichnet oder werden nachstehend zusammen mit der Beschreibung des bevorzugten Ausführungsbeispiels der Erfindung näher erläutert.

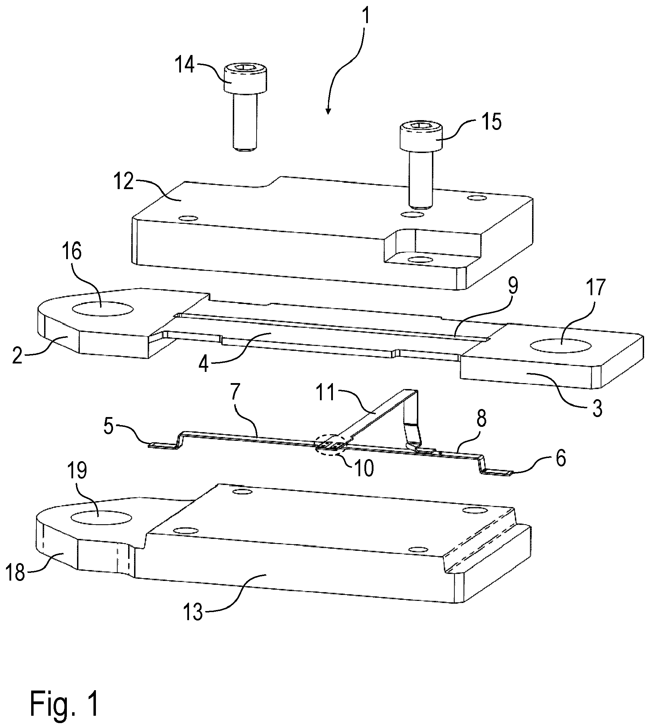

Im Folgenden wird nun unter Bezugnahme auf die Explosionsdarstellung in Figur 1 ein bevorzugtes Ausführungsbeispiel eines erfindungsgemäßen Strommesswiderstands 1 beschrieben.

Der Strommesswiderstand 1 weist zwei plattenförmige Anschlussteile 2, 3 auf, um den zu messenden elektrischen Strom in den Strommesswiderstand 1 einzuleiten bzw. von dem Strommesswiderstand 1 abzuführen. Die beiden plattenförmigen Anschlussteile 2, 3 bestehen in diesem Ausführungsbeispiel aus Kupfer, um Spannungsabfälle innerhalb der Anschlussteile 2, 3 zu vermeiden.

Zwischen die beiden Anschlussteile 2, 3 ist ein niederohmiges plattenförmiges Widerstandselement aus Nickel-Chrom oder Kupfer-Nickel eingesetzt, wobei das Widerstandselement 4 durch eine Verschweißung (bevorzugt Elektronenstrahlverschweißung) mit den beiden Anschlussteilen 2, 3 verbunden ist.

Bei einer Strommessung fließt der zu messende elektrische Strom also durch das Widerstandselement 4, so dass der Spannungsabfall über dem Widerstandselement 4 entsprechend dem Ohmschen Gesetz ein Maß für den zu messenden elektrischen Strom bildet. Zur Messung dieses Spannungsabfalls sind zwei Spannungsabgriffe 5, 6 vorgesehen, wobei der Spannungsabgriff 5 physisch und elektrisch mit dem Anschlussteil 2 verbunden ist, während der Spannungsabgriff 6 physisch und elektrisch mit dem anderen Anschlussteil 3 verbunden ist. An die beiden Spannungsabgriffe 5, 6 sind zwei Messleitungen 7, 8 angeschlossen, die als Streifenleiter ausgebildet sind und in einer Nut 9 in dem Widerstandselement 4 von den außen liegenden Anschlussteilen 2, 3 nach innen und dann in einem gemeinsamen Kabelstrang 11 durch ein Loch im oberen Wärmesenkenbauteil 12 nach außen geführt zu einem Anschlusspunkt 10 geführt sind, um die über dem Widerstandselement 4 abfallende elektrische Spannung messbar zu machen.

Darüber hinaus weist der Strommesswiderstand 1 zwei Wärmesenkenbauteile 12, 13 auf, die aus Aluminium mit einer eloxierten Oberflächenoxidschicht bestehen, wobei die beiden Wärmesenkenbauteile 12, 13 das Widerstandselement 4 an seiner Oberseite bzw. an seiner Unterseite vollflächig thermisch und physisch kontaktieren, um einen möglichst guten Wärmeübergang von dem Widerstandselement 4 auf die beiden Wärmesenkenbauteile 12, 13 zu erreichen. Zur Verbesserung des Wärmeübergangs ist zwischen dem Widerstandselement 4 und den beiden Wärmesenkenbauteilen 12, 13 eine Wärmeleitpaste angebracht. Bei der Montage werden die beiden Wärmesenkenbauteile 12, 13 durch Schrauben 14, 15 zusammengeschraubt.

Ferner ist noch zu erwähnen, dass sich in den beiden Anschlussteilen 2, 3 jeweils eine Anschlussbohrung 16, 17 befindet, um beispielsweise eine Stromklemme anschließen zu können.

In diesem Ausführungsbeispiel weist das Wärmesenkenbauteil 13 eine Zunge 18 auf, die seitlich in Deckung mit dem Anschlussteil 2 liegt und ebenfalls eine Anschlussbohrung 19 aufweist, wobei die beiden Anschlussbohrungen 16, 19 fluchten.

Die Erfindung ist nicht auf das vorstehend beschriebene bevorzugte Ausführungsbeispiel beschränkt. Vielmehr ist eine Vielzahl von Varianten und Abwandlungen möglich, die ebenfalls von dem Erfindungsgedanken Gebrauch machen und deshalb in den Schutzbereich fallen. Darüber hinaus beansprucht die Erfindung auch Schutz für den Gegenstand und die einzelnen Merkmale der Unteransprüche unabhängig von den in Bezug genommenen Ansprüchen. Insbesondere sind die kennzeichnenden Merkmale des Hauptanspruchs und die Merkmale d) und e) im Oberbegriff des Hauptanspruchs optional, d.h. die Erfindung umfasst auch Erfindungsvarianten ohne diese Merkmale, aber optional mit anderen Merkmals aus den Unteransprüchen.

### Bezugszeichenliste:

- 1: Strommesswiderstand
- 2, 3: Anschlussteile
- 4: Widerstandselement
- 5, 6: Spannungsabgriffe
- 7, 8: Messleitungen
- 9: Nut
- 10: Anschlusspunkt
- 11: Kabelstrang
- 12, 13: Wärmesenkenbauteile
- 14, 15: Schrauben
- 16, 17: Anschlussbohrung
- 18: Zunge
- 19: Anschlussbohrung

## Patentansprüche

1. Widerstand (1), insbesondere Strommesswiderstand zur Messung eines elektrischen Stroms, mit
a) einem ersten Anschlussteil (2) aus einem elektrisch leitfähigen Leitermaterial zum Einleiten eines elektrischen Stroms in den Widerstand (1),
b) einem zweiten Anschlussteil (3) aus einem elektrisch leitfähigen Leitermaterial zum Abführen des elektrischen Stroms aus dem Widerstand (1),
c) einem Widerstandselement (4), wobei
c1) das Widerstandselement (4) aus einem Widerstandsmaterial besteht, dessen spezifischer elektrischer Widerstand (1) größer ist als der spezifische elektrische Widerstand (1) des Leitermaterials der beiden Anschlussteile (2, 3), und
c2) das Widerstandselement (4) elektrisch zwischen dem ersten Anschlussteil (2) und dem zweiten Anschlussteil (3) angeordnet ist, so dass der elektrische Strom durch das Widerstandselement (4) fließt, und
c3) der elektrische Strom eine elektrische Verlustwärme in dem Widerstandselement (4) erzeugt,
d) zwei Spannungsabgriffen (5, 6) an den beiden Anschlussteilen (2, 3) zur Messung der über dem Widerstandselement (4) abfallenden elektrischen Spannung, und
e) zwei Messleitungen (7, 8), die an die beiden Spannungsabgriffe (5, 6) angeschlossen sind, und
f) einer elektrisch von dem Widerstandselement (4) isolierten Wärmesenke (12, 13), die thermisch und physisch mit dem Widerstandselement (4) verbunden ist und die in dem Widerstandselement (4) entstehende elektrische Verlustwärme mindestens teilweise aufnimmt und abführt,
**dadurch gekennzeichnet,**
g) dass die Wärmesenke (12, 13) ein Oberteil (13) und ein Unterteil (12) aufweist, die das Widerstandselement (4) oben bzw. unten thermisch und physisch kontaktieren,
h) dass die beiden Messleitungen (7, 8) auf einem Teil ihrer Länge zwischen dem Widerstandselement (4) und der Wärmesenke (12, 13) verlaufen,
i) dass die beiden Messleitungen (7, 8) auf einem Teil ihrer Länge in einer Nut (9) oder in einem Schlitz in dem Widerstandselement (4) verlaufen, und
j) dass die beiden Messleitungen (7, 8) auf einem Teil ihrer Länge parallel zur Stromflussrichtung in dem Widerstandselement (4) verlaufen.

2. Widerstand (1) nach Anspruch 1,
**dadurch gekennzeichnet,**
a) **dass** die Wärmesenke (12, 13) aus einem Wärmesenkenmaterial besteht, das eine größere spezifische Wärmekapazität aufweist als das Leitermaterial und/oder das Widerstandsmaterial, und/oder
b) **dass** das Wärmesenkenmaterial eine spezifische Wärmekapazität von mehr als 400 J/kg·K, 600 J/kg·K oder 800 J/kg·K aufweist, und/oder
c) **dass** die Wärmesenke (12, 13) eine wesentlich größere Wärmekapazität aufweist als das Widerstandselement (4), und/oder
d) **dass** die Wärmekapazität der Wärmesenke (12, 13) um einen Faktor von mindestens 10, 20 oder 30 größer ist als die Wärmekapazität des Widerstandselements (4), und/oder
e) **dass** die Wärmesenke (12, 13) ein wesentlich größeres Bauvolumen und/oder eine wesentlich größere Masse aufweist als das Widerstandselement (4), und/oder
f) **dass** das Wärmesenkenmaterial eine spezifische Wärmeleitfähigkeit von mehr als 100 W/m·K, 150 W/m·K oder 200 W/m·K aufweist, und/oder
g) **dass** die Wärmesenke (12, 13) aus Aluminium oder einer Aluminiumlegierung oder einem Aluminium-Kupfer plattierten Material besteht.

3. Widerstand (1) nach einem der vorhergehenden Ansprüche,
**dadurch gekennzeichnet, dass** die Wärmesenke (12, 13) das Widerstandselement (4) oben und unten auf seiner gesamten Fläche berührt.

4. Widerstand (1) nach einem der vorhergehenden Ansprüche,
**dadurch gekennzeichnet,**
a) **dass** die Wärmesenke (12, 13) aus einem elektrisch leitfähigen Material besteht, insbesondere aus Aluminium oder einer Aluminiumlegierung, und
b) **dass** die Wärmesenke (12, 13) eine elektrisch isolierende Oberflächenschicht aufweist, insbesondere eine eloxierte Oxidschicht.

5. Widerstand (1) nach einem der vorhergehenden Ansprüche,
**dadurch gekennzeichnet, dass** zwischen der Wärmesenke (12, 13) und dem Widerstandselement (4) ein Wärmeleitmittel angeordnet ist, insbesondere eine Wärmeleitpaste oder eine dünne Keramikschicht.

6. Widerstand (1) nach einem der vorhergehenden Ansprüche,
**dadurch gekennzeichnet,**
a) **dass** die beiden Messleitungen (7, 8) zumindest auf einem Teil ihrer Länge als Streifenleiter ausgebildet sind, und/oder
b) **dass** die beiden Messleitungen (7, 8) von den außen liegenden Spannungsabgriffen (5, 6) nach innen zu einem gemeinsamen Anschlusspunkt (10) geführt sind, und/oder
c) **dass** die Anschlussteile (2, 3) eine Prägung aufweist zur Aufnahme der Spannungsabgriffe (5, 6).

7. Widerstand (1) nach einem der vorhergehenden Ansprüche,
**dadurch gekennzeichnet, dass** die Wärmesenke (12, 13) mit dem Widerstandselement (4) und/oder mit den Anschlussteilen (2, 3) verschraubt, verschweißt, verlötet, verklebt oder vernietet ist.

8. Widerstand (1) nach einem der vorhergehenden Ansprüche,
**dadurch gekennzeichnet,**
a) **dass** das Widerstandselement (4) in der Mitte zwischen den beiden Anschlussteilen (2, 3) einen größeren Stromflussquerschnitt aufweist als außen an den Kontaktstellen zu den Anschlussteilen (2, 3), und/oder
b) **dass** das Widerstandselement (4) wesentlich dünner ist als die Anschlussteile (2, 3).

9. Widerstand (1) nach einem der vorhergehenden Ansprüche,
**dadurch gekennzeichnet,**
a) **dass** die Wärmesenke (12, 13) und zumindest eines der beiden Anschlussteile (2, 3) in einem Bereich in Deckung übereinander liegen, und/oder
b) **dass** die Wärmesenke (12, 13) eine Anschlussbohrung aufweist, und/oder
c) **dass** zumindest eines der Anschlussteile (2, 3) eine Anschlussbohrung aufweist, die mit der Anschlussbohrung in der Wärmesenke (12, 13) fluchtet.

10. Widerstand (1) nach einem der vorhergehenden Ansprüche,
**dadurch gekennzeichnet,**
a) **dass** das Widerstandsmaterial des Widerstandselements (4) eine Nickellegierung ist, insbesondere NiCr oder CuNi, und
b) **dass** das Widerstandsmaterial in der thermoelektrischen Spannungsreihe gegenüber Kupfer eine Thermospannung von weniger als 0,5 mV/100K, 0,3 mV/100K oder 0,2 mV/100K aufweist, und
c) **dass** das Widerstandsmaterial einen spezifischen elektrischen Widerstand (1) mit einem Temperaturkoeffizienten von weniger als 5·10⁻⁴K⁻¹, 2·10⁻⁴K⁻¹, 1·10⁻⁴K⁻¹ oder 5·10⁻⁵K⁻¹ aufweist, und
d) **dass** das Widerstandsmaterial niederohmig ist, und
e) **dass** das Widerstandsmaterial einen spezifischen elektrischen Widerstand (1) aufweist, der kleiner ist als 2^{∗}10⁻⁴ Ω·m, 2^{∗}10⁻⁵ Ω·m oder 2^{∗}10⁻⁶ Ω·m und
f) **dass** das Leitermaterial der Anschlussteile (2, 3) Kupfer oder eine Kupferlegierung ist, und/
g) **dass** das Leitermaterial einen spezifischen elektrischen Widerstand (1) aufweist, der kleiner ist als 10⁻⁵ Ω·m, 10⁻⁶ Ω·m oder 10⁻⁷ Ω·m und
h) **dass** die Anschlussteile (2, 3) mechanisch fest mit dem Widerstandselement (4) verbunden sind, insbesondere durch eine Schweißnaht, insbesondere durch eine Elektronenstrahlverschweißung, und
i) **dass** die Anschlussteile (2, 3) und/oder das Widerstandselement (4) plattenförmig sind, und
j) **dass** das Widerstandselement (4) mit der Wärmesenke (12, 13) eine wesentlich größere Kontaktfläche aufweist als mit den Anschlussteilen (2, 3).

11. Widerstand (1) nach einem der vorhergehenden Ansprüche,
**dadurch gekennzeichnet, dass** die zwei Anschlussteile (2, 3) durch flächenförmiges Auflöten oder Aufschweißen von Platten aus dem Leitermaterial, insbesondere aus Kupfer, auf dem verlängerten Widerstandsmaterial erzeugt werden.
